# EUROPEAN PATENT APPLICATION

(11) **EP 0 833 379 A2**
(43) Date of publication of application: **01.04.1998**
(21) Application number: 97307566.6
(22) Date of filing: 26.09.1997
(51) Int. Cl.: H01L 21/335, H01L 21/76, H01L 29/778

(54) **Semiconductor device and manufacturing method thereof**

(30) Priority: 27.09.1996 JP 256361/96; 24.10.1996 JP 282584/96
(71) Applicant: SANYO ELECTRIC CO. LTD, Moriguchi-shi, Osaka-fu 570 (JP)
(72) Inventor: Fujii, Emi, Ikoma-gun, Nara-ken 636 (JP); Matsushita, Shigeharu, Katano-shi, Osaka-fu 576 (JP); Inoue, Daijiro, Kyoto-shi, Kyoto-fu 615 (JP); Matsumura, Kohji, Hirakata-shi, Osaka-fu 573 (JP)
(74) Representative: Calderbank, Thomas Roger

(57) **Abstract**

An SiN anneal protection film 2 is formed on a GaAs epitaxial growth substrate 1. A dummy gate 3 is formed with photoresist to form n⁺ layers 4a and 4b and the dummy gate length is reduced. An SiO₂ film 5 is formed all over the SiN anneal protection film 2 and the dummy gate 3, and the SiO₂ film 5 attached to the sidewall of the dummy gate 4 is selectively etched, and a reverse dummy-gate pattern 50 is formed by a lift-off process. Annealing is applied for a short time to activate the n⁺ layers 4a and 4b. After that, mesa etching is performed for device isolation.

## Description

The present invention relates to a semiconductor device having a stepped portion for device isolation and a manufacturing method thereof.

For field-effect transistors using compound semiconductors such as GaAs, various self-aligned processes are developed to reduce the effect of the surface depletion layer to reduce the source resistance. Modulation-Doped Field-Effect Transistors (MODFET) using a two-dimensional electron gas layer and the like to increase the mobility of electrons are being developed, too.

When manufacturing such a field-effect transistor, predetermined layers are formed on a GaAs substrate by MBE (Molecular-Beam Epitaxy), or MOCVD (Metal Organic Chemical Vapor Deposition), for example, and a mesa etching process is applied to the epitaxial growth substrate for the purpose of device isolation.

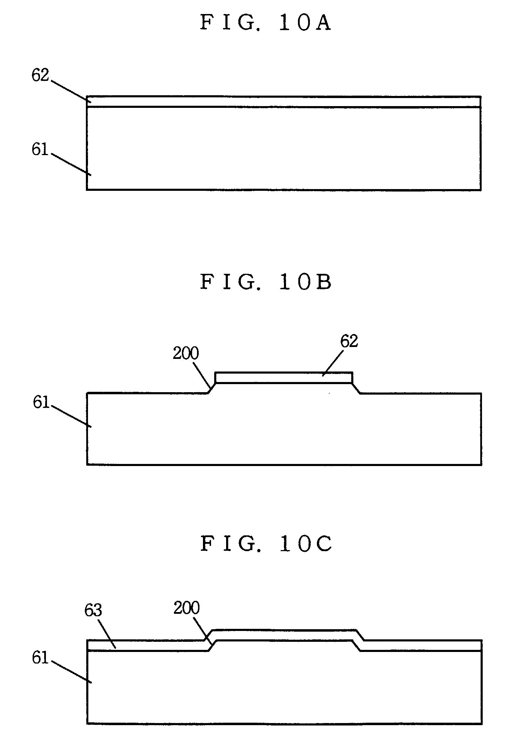

Fig.10A-Fig.10H provide process sections showing a conventional method of manufacturing a field-effect transistor using the mesa etching process. In this example, a self-aligned process utilizing a reverse dummy-gate pattern is conducted by using a GaAs epitaxial growth substrate.

First, as shown in Fig.10A, an SiN protection film 62 having a thickness of 50 nm is formed by ECR-plasma-CVD (Electron Cyclotron Resonance Plasma Chemical Vapor Deposition) on a GaAs epitaxial growth substrate 61. This SiN protection film 62 is formed to prevent contamination of the surface of the epitaxial growth substrate 61 by photoresist.

Next, as shown in Fig.10B, photoresist (not shown) for mesa etching is formed on the SiN protection film 62 and the exposed part of the SiN protection film 62 is etched, and then a mesa etching process is applied for device isolation. Thus a mesa pattern (a plateau-shaped pattern) 200 is formed on the epitaxial growth substrate 61.

Subsequently, as shown in Fig.10C, the SiN protection film 62 is removed and an SiN anneal protection film 63 having a thickness of 50 nm is formed over the entire surface of the epitaxial growth substrate 61 by ECR-plasma-CVD. The SiN anneal protection film 63 prevents the surface of the epitaxial growth substrate 61 from being thermally etched in the heat treatment described later.

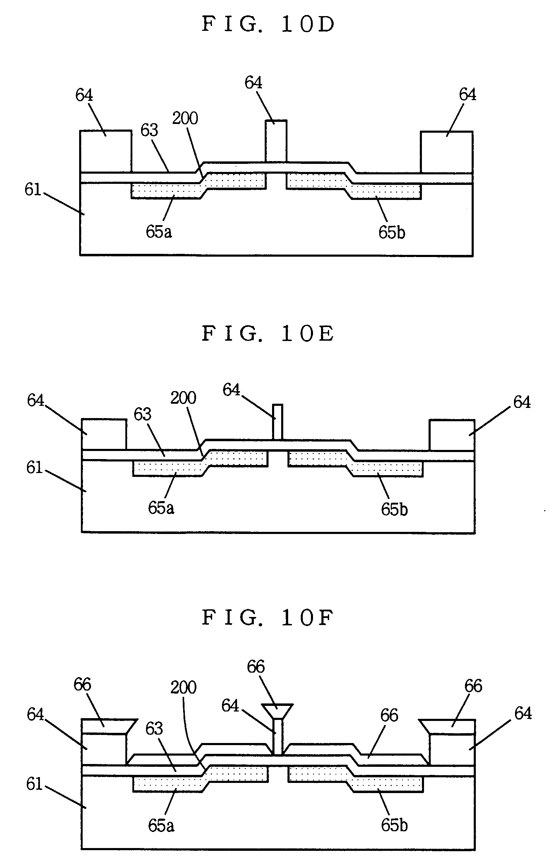

Next, as shown in Fig.10D, a dummy gate 64 is formed with photoresist on the SiN anneal protection film 63. Then, by using the dummy gate 64 as a mask, n⁺ layers (high-concentration doped regions) 65a and 65b for obtaining ohmic contact are formed in the surface of the epitaxial growth substrate 61 by a self-aligned ion implantation.

Furthermore, as shown in Fig.10E, the dummy gate 64 is etched by oxygen plasma to reduce the dummy gate length.

Next, as shown in Fig.10F, an SiO₂ film 66 is formed all over the SiN anneal protection film 63 and the dummy gate 64 by ECR-plasma-CVD. Subsequently, the SiO₂ film 66 is selectively etched only in the part attached to the sidewall of the dummy gate 64 by using buffered hydrofluoric acid composed of a mixed solution containing HF and NH₄F in a ratio of 1:100.

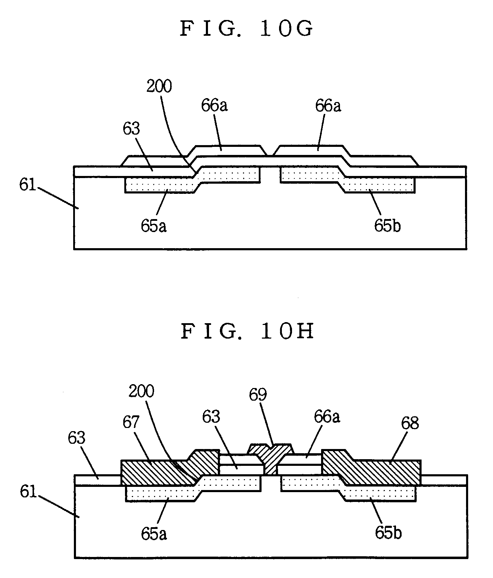

Next, as shown in Fig.10G, the dummy gate 64 is removed by lifting-off together with the SiO₂ film 66 thereon to reverse the pattern of the dummy gate 64. Thus the reverse dummy-gate pattern 66a composed of the SiO₂ film 66 is formed. In this condition, an annealing process is applied for a short time by using a halogen lamp to activate the n⁺ layers 65a, 65b.

Subsequently, as shown in Fig.10H, a source electrode 67 and a drain electrode 68 of AuGe/Ni/Au are formed on the n⁺ layers 65a and 65b by patterning technology and a gate electrode 69 of Ti/Pd/Au is formed on the epitaxial growth substrate 61 between the n⁺ layers 65a and 65b.

Finally, a protection film (not shown) for moisture resistance or the like is formed on the entire surface and electrodes (not shown) for connection with an external bias power-supply are formed on the source electrode 67 and the drain electrode 68 by using patterning technology with photoresist.

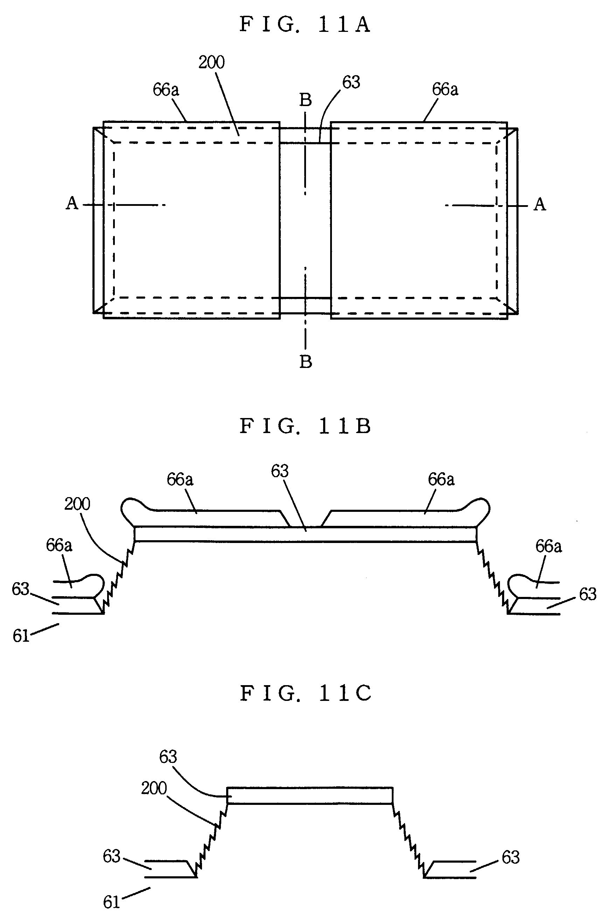

In the conventional method of manufacturing the field-effect transistor described above, annealing (activating annealing) is performed for a short time with a halogen lamp to activate the n⁺ layers 65a, 65b in the process step shown in Fig.10G. Fig.11A is a schematic plan showing the mesa pattern in the activating annealing process, and Fig.11B shows the cross section taken along the line A-A in Fig.11A and Fig.11C shows the cross section taken along the line B-B in Fig.11A.

As shown in Fig.11B and Fig.11C, the reverse dummy-gate pattern 66a formed of the SiO₂ film and the SiN anneal protection film 63 on the sidewall of the mesa pattern 200 are broken by the effects of the film thickness and the stresses in the activating annealing process. Then the sidewall of the mesa pattern 200 is not protected by the SiN anneal protection film 63 and is thus subjected to thermal etching. This increases lattice defects in the device region to add to noise sources, which deteriorates characteristics of the field-effect transistor.

An object of the present invention is to provide a semiconductor device having a stepped portion whose sidewall is prevented from being thermally etched in a heat treatment and its manufacturing method.

A method of manufacturing a semiconductor device according to the present invention includes the steps of: doping a semiconductor substrate with an impurity element to form an impurity-doped region; applying a heat treatment to activate the impurity-doped region; and forming a stepped portion for device isolation on the semiconductor substrate by etching after the heat treatment.

In this case, since the heat treatment for activating the impurity-doped region is performed before the formation of the stepped portion for device isolation, the sidewall of the stepped portion is not subjected to thermal etching in the heat treatment. Accordingly, the lattice defects in the device region are reduced and the noise sources are reduced, and the characteristics of the semiconductor device are improved.

Particularly, it is preferred that the stepped portion forming step includes removing a certain region of the semiconductor substrate by mesa etching.

This way, a mesa-shaped device region is formed in the semiconductor substrate and a recessed device isolation region is formed adjacent to the device region.

The step of doping with the impurity element may include forming a pair of impurity-doped regions at a certain distance in the semiconductor substrate, and the stepped portion forming step may include forming a mesa-shaped device region including the pair of impurity-doped regions.

In this case, the sidewall of the mesa-shaped device region is not subjected to thermal etching in the heat treatment. This allows reduction of lattice defects in the device region and hence reduction of noise sources, which provides improved characteristics.

The semiconductor device manufacturing method may further include the step of forming a gate electrode on the semiconductor substrate between the pair of impurity-doped regions after the mesa-shaped device region is formed. In this case, the noise sources are reduced and therefore a field-effect-type semiconductor device with improved characteristics can be obtained.

Particularly, the semiconductor substrate preferably includes a first semiconductor layer doped with an impurity element of one conductivity type, a second semiconductor layer formed on the first semiconductor layer, composed of the same semiconductor material as the first semiconductor layer, and undoped or having a carrier concentration of 10¹⁶cm⁻³ or lower, and a third semiconductor layer formed on the second semiconductor layer and forming a heterojunction with the second semiconductor layer.

The word "undoped" means that no impurity elements are intentionally introduced as dopant in the epitaxial growth process.

In a semiconductor device using such a semiconductor substrate, the carrier concentration in the vicinity of the heterojunction between the second semiconductor layer and the third semiconductor layer is reduced because the second semiconductor layer is undoped or has a carrier concentration of 10¹⁶cm⁻³ or lower. Since vacancies are formed in the heat treatment in production process by movement of carriers, it is thought that the number of vacancies decreases as the carrier concentration decreases. When vacancies decrease in number, the diffusion of dopant in the first semiconductor layer and the mutual diffusion of component elements in the vicinity of the heterojunction interface are suppressed and defects caused by vacancies are reduced. Then the variations of the semiconductor layers in the heat treatment become smaller, which improves the reproducibility of previously designed device characteristics and the uniformity in a wafer and suppresses deterioration of the device characteristics. This reduces the error between characteristics of actually produced devices and designed characteristics, and therefore semiconductor devices having a good performance can be stably manufactured with a good controllability.

Particularly, preferably, the first semiconductor layer has a larger electron affinity than the third semiconductor layer, the one-conductivity-type impurity element is an n-type impurity element, and the second semiconductor layer has an electron concentration of 10¹⁶cm⁻³ or lower in the vicinity of the interface between the second semiconductor layer and the third semiconductor layer.

In this case, it is thought that the number of vacancies in the vicinity of the heterojunction interface decreases when the electron concentration in the vicinity of the heterojunction interface becomes 10¹⁶cm⁻³ or lower because the vacancies are caused by exchange of electrons in the heat treatment. When the tendency toward the formation of vacancies is reduced, the diffusion of dopant in the first semiconductor layer and the mutual diffusion of component elements in the vicinity of the heterojunction interface are suppressed and defects due to vacancies are reduced. Then the variations of the doping profile and the edge profile of the conduction band by thermal processing become smaller, which improves the reproducibility of the device characteristics and the uniformity in a wafer, and deterioration of the device characteristics is suppressed.

Particularly, the first semiconductor layer, the second semiconductor layer and the third semiconductor layer may each be formed of a Group III-V compound semiconductor. In this case, formation of vacancies of the Group III elements or the Group V elements is suppressed in the heat treatment.

Particularly, the first semiconductor layer and the second semiconductor layer may be formed of GaAs and the third semiconductor layer may be formed of AlGaAs or InGaP. The first semiconductor layer and the second semiconductor layer may be formed of InGaAs, and the third semiconductor layer of GaAs, AlGaAs, InGaP, InAlAs, or InP. In this case, compound semiconductor device having good performance can be stably produced with good controllability.

A method of manufacturing a semiconductor device according to another aspect of the present invention includes the steps of: forming a film serving as a source of diffusion of an impurity element on a semiconductor substrate; applying a heat treatment to cause the impurity element to diffuse into the semiconductor substrate from the film serving as a source of diffusion; and forming a stepped portion for device isolation on the semiconductor substrate by etching after the heat treatment.

In this case, since the heat treatment for thermal diffusion of the impurity element is performed before the formation of the stepped portion for device isolation, the sidewall of the stepped portion is not subjected to thermal etching in the heat treatment. This lessens the lattice defects in the device region, and hence the noise sources, thus improving the characteristics of the semiconductor device.

Particularly, it is preferred that the stepped portion forming step includes removing a certain region of the semiconductor substrate by mesa etching.

This way, a mesa-shaped device region is formed in the semiconductor substrate and a recessed device isolation region is formed adjacent to the device region.

Particularly, the heat treatment step may include forming a pair of impurity-doped regions at a certain distance in the semiconductor substrate, and the stepped portion forming step may include forming a mesa-shaped device region including the pair of impurity-doped regions.

In this case, the sidewall of the mesa-shaped device region is not subjected to thermal etching in the heat treatment. Hence lattice defects in the device region are reduced and the noise sources are reduced, which provides the semiconductor device with improved characteristics.

The semiconductor device manufacturing method may further include the step of forming a gate electrode on the semiconductor substrate between the pair of impurity-doped regions after the mesa-shaped device region is formed.

In this case, the noise sources are reduced and therefore a field-effect-type semiconductor device with improved characteristics can be obtained.

Particularly, the semiconductor substrate preferably includes a first semiconductor layer doped with an impurity element of one conductivity type, a second semiconductor layer formed on the first semiconductor layer, composed of the same semiconductor material as the first semiconductor layer, and undoped or having a carrier concentration of 10¹⁶cm⁻³ or lower, and a third semiconductor layer formed on the second semiconductor layer and forming a heterojunction with the second semiconductor layer.

In a semiconductor device using such a semiconductor substrate, the carrier concentration in the vicinity of the heterojunction between the second semiconductor layer and the third semiconductor layer is reduced because the second semiconductor layer is undoped or has a carrier concentration of 10¹⁶cm⁻³ or lower. Since vacancies are formed by movement of carriers in the heat treatment in production process, it is thought that the number of vacancies decreases as the carrier concentration decreases. The reduction of vacancies suppresses the diffusion of dopant in the first semiconductor layer and the mutual diffusion of component elements in the vicinity of the heterojunction interface and the formation of defects. This lessens the variations of the semiconductor layers in the heat treatment, which improves the reproducibility of previously designed device characteristics and the uniformity in a wafer and suppresses deterioration of the device characteristics. Then the error between characteristics of actually produced devices and the designed characteristics becomes smaller to enable high-performance semiconductor devices to be stably manufactured with good controllability.

Particularly, preferably, the first semiconductor layer has a larger electron affinity than the third semiconductor layer, the one-conductivity-type impurity element is an n-type impurity element, and the second semiconductor layer has an electron concentration of 10¹⁶cm⁻³ or lower in the vicinity of the interface between the second semiconductor layer and the third semiconductor layer.

In this case, it is thought that the number of vacancies in the vicinity of the heterojunction interface decreases when the electron concentration in the vicinity of the heterojunction interface becomes 10¹⁶cm⁻³ or lower because vacancies are caused by exchange of electrons in the heat treatment. When the tendency toward the formation of vacancies is reduced, the diffusion of dopant in the first semiconductor layer and the mutual diffusion of component elements in the vicinity of the heterojunction interface are suppressed and defects due to vacancies are reduced. Then the variations of the doping profile and the edge profile of the conduction band by thermal processing become smaller, which improves the reproducibility and the uniformity in a wafer of the device characteristics and suppresses deterioration of the device characteristics.

The first semiconductor layer, the second semiconductor layer and the third semiconductor layer may each be formed of a Group III-V compound semiconductor. In this case, formation of vacancies of the Group III elements or the Group V elements is suppressed in the heat treatment.

Further, the first semiconductor layer and the second semiconductor layer may be formed of GaAs and the third semiconductor layer may be formed of AlGaAs or InGaP. The first semiconductor layer and the second semiconductor layer may be formed of InGaAs, and the third semiconductor layer of GaAs, AlGaAs, InGaP, InAlAs, or InP. In this case, high-performance compound semiconductor devices can be stably produced with a good controllability.

A method of manufacturing a semiconductor device according to a further aspect of the present invention includes the steps of: forming a certain layer in or on a semiconductor substrate; applying a heat treatment to the semiconductor substrate having the certain layer; and forming a stepped portion for device isolation on the semiconductor substrate after the heat treatment.

In this case, the sidewall of the stepped portion is not subjected to thermal etching in the heat treatment since the stepped portion for device isolation is formed after the process of heat treatment. This achieves reduction of lattice defects in the device region and hence reduction of noise sources, thus enabling improvement in the characteristics.

Particularly, the semiconductor device manufacturing method may further include the step of forming a field-effect-type semiconductor device in a region isolated by the stepped portion. In this case, the noise sources of the field-effect-type semiconductor device are reduced and the characteristics are improved.

Particularly, the semiconductor substrate may include a compound semiconductor layer. In this case, the noise sources in the compound semiconductor device are reduced and the characteristics are improved.

A semiconductor device according to a further aspect of the present invention includes: a semiconductor substrate including a certain layer; a pair of high-concentration doped regions formed at a certain distance in the semiconductor substrate by doping with an impurity element; a gate region formed between the pair of high-concentration doped regions; and a mesa-shaped device region including the gate region and the pair of high-concentration doped regions and formed in the surface of the semiconductor substrate, the sidewall of the mesa-shaped device region being not subjected to thermal etching.

Particularly, it is preferred that, in the gate width direction, the width of the mesa-shaped device region in the gate region is equal to or smaller than the width of the mesa-shaped device region in the high-concentration doped regions.

In this semiconductor device, since the sidewall of the mesa-shaped device region is not thermally etched, a number of lattice defects and a number of noise sources in the device region are reduced, and therefore the characteristics are improved.

Particularly, the semiconductor substrate preferably includes a first semiconductor layer doped with an impurity element of one conductivity type, a second semiconductor layer formed on the first semiconductor layer, composed of the same semiconductor material as the first semiconductor layer, and undoped or having a carrier concentration of 10¹⁶cm⁻³ or lower, and a third semiconductor layer formed on the second semiconductor layer and forming a heterojunction with the second semiconductor layer.

In a semiconductor device using such a semiconductor substrate, the carrier concentration in the vicinity of the heterojunction between the second semiconductor layer and the third semiconductor layer is reduced because the second semiconductor layer is undoped or has a carrier concentration of 10¹⁶cm⁻³ or lower. Since vacancies are formed by movement of carriers in the heat treatment in production process, it is thought that the number of vacancies decreases as the carrier concentration decreases. The reduction of vacancies suppresses the diffusion of dopant in the first semiconductor layer and the mutual diffusion of component elements in the vicinity of the heterojunction interface and the formation of defects. This lessens the variations of the semiconductor layers in the heat treatment, which improves the reproducibility of previously designed device characteristics and the uniformity in a wafer and suppresses deterioration of the device characteristics. Then the error between characteristics of actually produced devices and the designed characteristics becomes smaller to enable high-performance semiconductor devices to be stably manufactured with good controllability.

Particularly, preferably, the first semiconductor layer has a larger electron affinity than the third semiconductor layer, the one-conductivity-type impurity element is an n-type impurity element, and the second semiconductor layer has an electron concentration of 10¹⁶cm⁻³ or lower in the vicinity of the interface between the second semiconductor layer and the third semiconductor layer.

In this case, it is thought that the number of vacancies in the vicinity of the heterojunction interface decreases when the electron concentration in the vicinity of the heterojunction interface becomes 10¹⁶cm⁻³ or lower because vacancies are caused by exchange of electrons in the heat treatment. When the tendency toward the formation of vacancies is reduced, the diffusion of dopant in the first semiconductor layer and the mutual diffusion of component elements in the vicinity of the heterojunction interface are suppressed and defects due to vacancies are reduced. Then the variations of the doping profile and the edge profile of the conduction band by thermal processing become smaller, which improves the reproducibility and the uniformity in a wafer of the device characteristics and suppresses deterioration of the device characteristics.

The first semiconductor layer, the second semiconductor layer and the third semiconductor layer may each be formed of a Group III-V compound semiconductor. In this case, formation of vacancies of the Group III elements or the Group V elements is suppressed in the heat treatment.

Further, the first semiconductor layer and the second semiconductor layer may be formed of GaAs and the third semiconductor layer may be formed of AlGaAs or InGaP. The first semiconductor layer and the second semiconductor layer may be formed of InGaAs, and the third semiconductor layer of GaAs, AlGaAs, InGaP, InAlAs, or InP. In this case, high-performance compound semiconductor devices can be stably produced with a good controllability.

A semiconductor device according to a further aspect of the present invention includes: a first semiconductor layer doped with an impurity element of one conductivity type; a second semiconductor layer formed on the first semiconductor layer, formed of the same semiconductor material as the first semiconductor layer, and undoped or having a carrier concentration of 10¹⁶cm⁻³ or lower; and a third semiconductor layer formed on the second semiconductor layer and forming a heterojunction with the second semiconductor layer.

In such a semiconductor device, the carrier concentration in the vicinity of the heterojunction between the second semiconductor layer and the third semiconductor layer is reduced because the second semiconductor layer is undoped or has a carrier concentration of 10¹⁶cm⁻³ or lower. Since vacancies are formed in the heat treatment by movement of carriers, it is thought that the number of vacancies decreases as the carrier concentration decreases. The decrease of vacancies in number suppresses the diffusion of dopant in the first semiconductor layer and the mutual diffusion of component elements in the vicinity of the heterojunction interface and enables reduction of defects. Then the variations of the semiconductor layers due to the heat treatment decrease to improve the reproducibility of previously designed device characteristics and the uniformity in a wafer, and deterioration of the device characteristics is suppressed. This reduces the error between characteristics of actually produced devices and the designed characteristics, thus enabling stable production of high-performance semiconductor devices with a good controllability.

Particularly, preferably, the first semiconductor layer has a larger electron affinity than the third semiconductor layer, the one-conductivity-type impurity element is an n-type impurity element, and the second semiconductor layer has an electron concentration of 10¹⁶cm⁻³ or lower in the vicinity of the interface between the second semiconductor layer and the third semiconductor layer.

In this case, it is thought that the number of vacancies in the vicinity of the heterojunction interface decreases when the electron concentration in the vicinity of the heterojunction interface becomes 10¹⁶cm⁻³ or lower because vacancies are caused by exchange of electrons in the heat treatment. When the tendency toward the formation of vacancies is reduced, the diffusion of dopant in the first semiconductor layer and the mutual diffusion of component elements in the vicinity of the heterojunction interface are suppressed and defects due to vacancies are reduced. Then the variations in the doping profile and in the edge profile of the conduction band due to the thermal processing become smaller, which improves the reproducibility and the uniformity in a wafer of the device characteristics and suppresses deterioration of the device characteristics.

Particularly, the first semiconductor layer, the second semiconductor layer and the third semiconductor layer may each be formed of a Group III-V compound semiconductor. In this case, formation of vacancies of the Group III elements or the Group V elements is suppressed in the heat treatment.

Particularly, the first semiconductor layer and the second semiconductor layer may be formed of GaAs and the third semiconductor layer may be formed of AlGaAs or InGaP. The first semiconductor layer and the second semiconductor layer may be formed of InGaAs, and the third semiconductor layer may be formed of GaAs, AlGaAs, InGaP, InAlAs, or InP. In this case, high-performance compound semiconductor devices can be stably produced with good controllability.

These and other objects, features, aspects and advantages of the present invention will become more apparent from the following detailed description of the present invention when taken in conjunction with the accompanying drawings.

Figs.1A-1G provide process sections showing a method of manufacturing a field-effect transistor according to a first embodiment of the present invention.

Fig.2 is a schematic cross section showing the structure of the epitaxial growth substrate used in the field-effect transistor of the first embodiment of the present invention.

Fig.3 is a schematic cross section showing the structure of the field-effect transistor according to the first embodiment of the present invention.

Figs.4A-4C provide a schematic plan of the mesa pattern in the mesa etching process in the field-effect transistor manufacturing method according to the first embodiment of the present invention, the cross section along the line X-X, and the cross section along the line Y-Y.

Figs.5A-5D show process sections in a method of manufacturing a field-effect transistor according to a second embodiment of the present invention.

Fig.6 is a schematic cross section showing the structure of an epitaxial growth substrate for a field-effect transistor according to a third embodiment of the present invention.

Fig.7 is a schematic cross section showing the structure of the field-effect transistor of the third embodiment using the epitaxial growth substrate shown in Fig.6.

Fig.8 is a schematic cross section showing the structure of an epitaxial growth substrate for a field-effect transistor according to a fourth embodiment of the present invention.

Fig.9 is a schematic cross section showing the structure of the field-effect transistor of the fourth embodiment using the epitaxial growth substrate shown in Fig.8.

Figs.10A-10H provide process sections showing a conventional method of manufacturing a field-effect transistor.

Figs.11A-11C provide a schematic plan of the mesa pattern in the activating annealing process in the conventional field-effect transistor manufacturing method, the cross section along the line A-A, and the cross section along the line B-B.

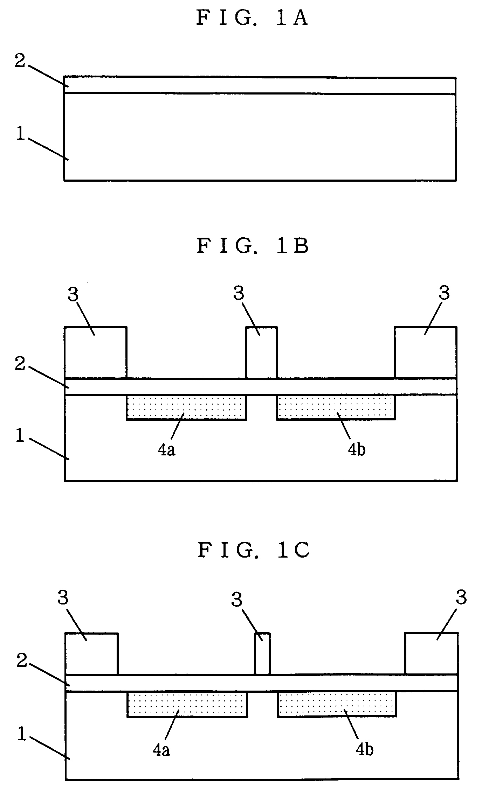

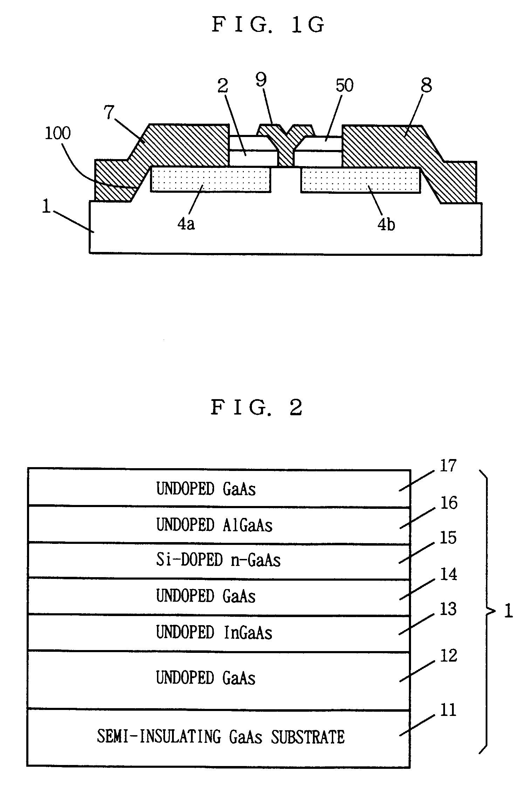

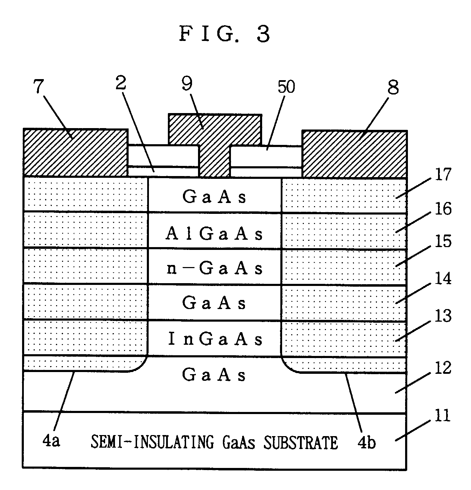

Fig.1A-Fig.1G show process sections of a method of manufacturing a field-effect transistor according to a first embodiment of the present invention. Fig.2 is a schematic cross section showing the structure of the epitaxial growth substrate used in the field-effect transistor of this embodiment and Fig.3 is a schematic cross section showing the structure of the field-effect transistor of this embodiment.

As shown in Fig.2, sequentially formed by epitaxial growth on a semi-insulating GaAs substrate 11 are a 8000-Å-thick undoped GaAs layer (buffer layer) 12, a 100-Å-thick undoped InGaAs layer (low-noise drift layer) 13, a 50-Å-thick undoped GaAs layer 14, a 400-Å-thick Si-doped n-type GaAs layer (high-power drift layer) 15, a 300-Å-thick undoped AlGaAs layer (barrier layer) 16, and a 50-A-thick undoped GaAs layer 17. The n-type GaAs layer 15 has a doping concentration of 1X10¹⁸cm⁻³. The layers 12-17 are continuously grown at a growth temperature of 500°C. The GaAs epitaxial growth substrate 1 is thus formed.

In this embodiment, a self-aligned process utilizing a reverse dummy-gate pattern is conducted by using this GaAs epitaxial growth substrate 1.

First, as shown in Fig.1A, an SiN anneal protection film 2 having a thickness of 50 nm is formed by ECR-plasma-CVD on the GaAs epitaxial growth substrate 1 having the structure shown in Fig.2. This SiN protection film 2 is composed of a double-layered film of SiN.

Next, as shown in Fig.1B, a dummy gate 3 is formed with photoresist and n⁺ layers (high-concentration doped regions) 4a and 4b for obtaining ohmic contact are formed in the surface of the epitaxial growth substrate 1 by a self-aligned ion implantation by using the dummy gate 3 as a mask.

Next, as shown in Fig.1C, the dummy gate 3 is etched by oxygen plasma to reduce the dummy gate length. As can be seen from the following process steps, this process step defines the distances between the ends of the gate electrode and the inner ends of the n⁺ layers 4a and 4b. Each of the distances is usually about 200 to 500 nm.

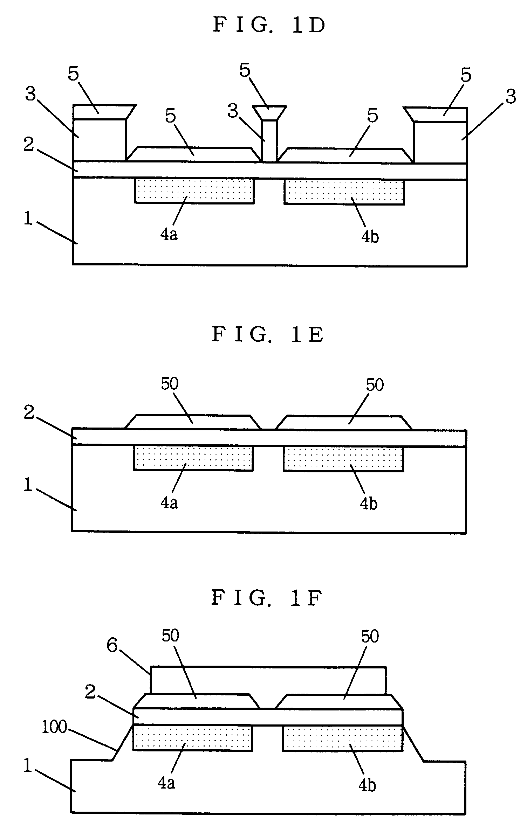

Further, as shown in Fig.1D, an SiO₂ film 5 is formed all over the SiN anneal protection film 2 and the dummy gate 3 by ECR-plasma-CVD. Subsequently, the SiO₂ film 5 is selectively etched only in the part attached to the sidewall of the dummy gate 3 by using a buffered hydrofluoric acid composed of a mixed solution of HF and NH₄F in the ratio of 1:100.

Next, as shown in Fig.1E, the dummy gate 3 is removed by a lifting-off process together with the SiO₂ film 5 thereon to reverse the pattern of the dummy gate 3. A reverse dummy-gate pattern 50 composed of the SiO₂ film 5 is thus formed. Then an annealing (activating annealing) process is applied for a short time with a halogen lamp to activate the n⁺ layers 4a and 4b.

Subsequently, as shown in Fig.1F, a photoresist pattern 6 is formed on the reverse dummy-gate pattern 50 and the SiN anneal protection film 2, and the exposed part of the SiN anneal protection film 2 is etched. Next, mesa etching is applied for device isolation by using a mixed solution of tartaric acid and hydrogen peroxide. The mesa pattern 100 is thus formed.

Next, as shown in Fig.1G, the photoresist pattern 6 for mesa etching is removed and then a source electrode 7 and a drain electrode 8 formed of AuGe/Ni/Au are formed respectively on the n⁺ layers 4a and 4b by using patterning technology, and a gate electrode 9 formed of Ti/Pd/Au is formed on the epitaxial growth substrate 1 between the n⁺ layers 4a and 4b.

Finally, a protection film (not shown) for moisture resistance or the like is formed all over the surface and electrodes (not shown) for connection with an external bias power-supply are formed on the source electrode 7 and the drain electrode 8 by using patterning technology with photoresist.

A field-effect transistor having the structure shown in Fig.3 is thus manufactured. This field-effect transistor has both low-noise and high-power characteristics, which is called a TMT (Two-Mode Channel FET) device.

In the field-effect transistor shown in Fig.3, the depletion layer downwardly extends when the gate potential is deep and electrons supplied from the n-type GaAs layer 15 mainly drift in the undoped InGaAs layer 13. In this case, since the electrons are well confined in the quantum well in the undoped InGaAs layer 13, they are less affected by impurities in the heavily doped n-type GaAs layer 15, providing a supper-low-noise characteristic.

On the other hand, when the gate potential is shallow, the depletion layer shrinks and the electrons mainly drift in the n-type GaAs layer 15. Accordingly the heavily doped n-type GaAs layer 15 serves as a channel, providing a high and plateau-shaped transconductance, and hence a high-power characteristic.

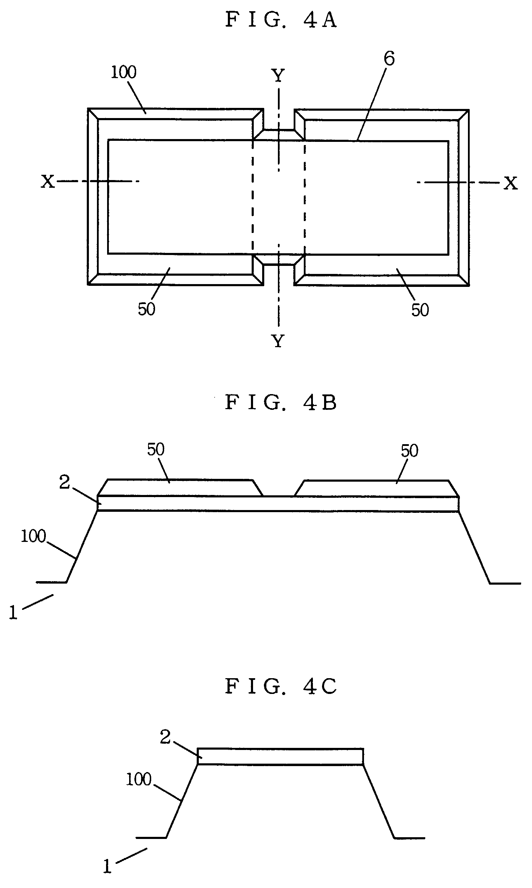

Fig.4A is a schematic plan view showing the mesa pattern in mesa etching, Fig.4B shows the cross section along the line X-X in Fig.4A and Fig.4C shows the cross section along the line Y-Y in Fig.4A.

As shown in Fig.4B and Fig.4C, the sidewall of the mesa pattern 100 is not thermally etched because the activating annealing process step shown in Fig.1E is conducted before the mesa etching process step shown in Fig.1F in the field-effect transistor manufacturing method of this embodiment. This reduces lattice defects in the device region of the field-effect transistor to reduce noise sources, which results in improvement of the characteristics of the field-effect transistor.

We fabricated a field-effect transistor having the structure shown in Fig.3 by using the manufacturing method of the first embodiment and another field-effect transistor having the same structure by using the conventional manufacturing method for comparison and measured their characteristics. Table 1 shows the measurements.

**Table 1**

| | Comparison | Embodiment |
|---|---|---|
| Drain saturation current Idss (mA) | 107 | 132 |
| Transconductance gm (mS) | 94 | 102 |
| Phase noise characteristic (dBc/Hz) Oscillation frequency 11.3 GHz (off carrier 1kHz) | -56 | -66 |

As shown in Table 1, as compared with the field-effect transistor for comparison, the field-effect transistor of this embodiment provided larger drain saturation current Idss and transconductance gm and an improved phase noise characteristic. The drain saturation current Idss and the transconductance gm are those at a gate voltage Vg =0[V]. The results show that the method of manufacturing the field-effect transistor of the embodiment allows reduction of lattice defects, and hence reduction of noise sources, and improves the characteristics.

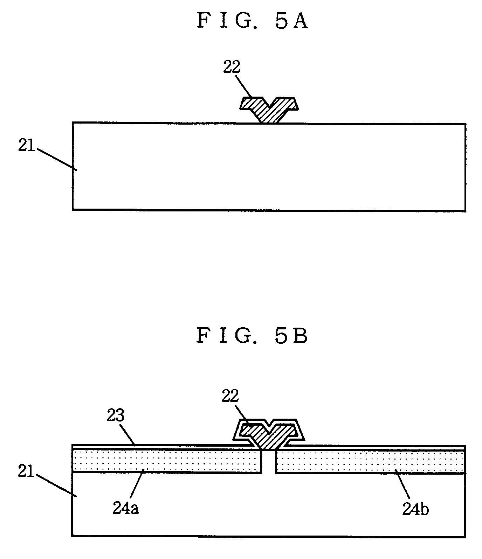

Figs.5A-5D provide process sections showing a field-effect transistor manufacturing method according to a second embodiment of the invention.

First, as shown in Fig.5A, a T-shaped gate electrode 22 of refractory metal is formed on a GaAs epitaxial growth substrate 21.

Next, as shown in Fig.5B, a 50-nm-thick SiOₓ/SiN double-layered film 23 is formed by plasma CVD all over the epitaxial growth substrate 21 and the gate electrode 22 and annealing is applied for a short time with a halogen lamp. Here, X<2. Then, with SiOₓ in the SiOₓ/SiN double-layered film 23 serving as a source of diffusion, Si diffuses into the epitaxial growth substrate 21 to form n⁺ layers 24a and 24b. SiN in the SiOₓ/SiN double-layered film 23 serves as a protection film.

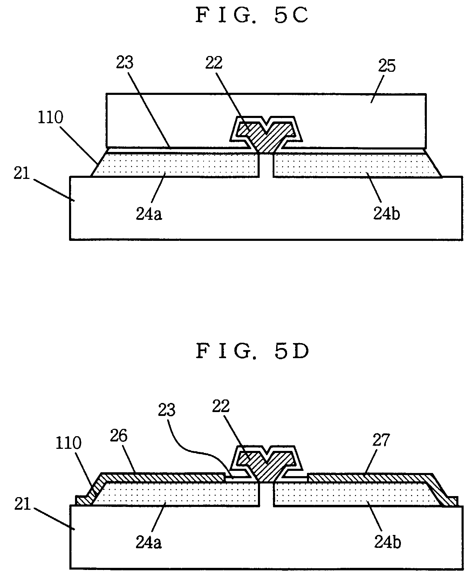

Next, as shown in Fig.5C, a photoresist pattern 25 is formed on the SiOₓ/SiN double-layered film 23 and the exposed part of the SiOₓ/SiN double-layered film 23 is etched, and then mesa etching is applied for device isolation. This forms a mesa pattern 110 on the epitaxial growth substrate 21.

Subsequently, as shown in Fig.5D, the photoresist pattern 25 for mesa etching is removed and then a source electrode 26 and a drain electrode 27 are formed by using patterning technology on the n⁺ layers 24a and 24b, respectively.

Finally, a protection film (not shown) for moisture resistance or the like is formed all over the surface and electrodes (not shown) for connection with an external bias power-supply are formed on the source electrode 26 and the drain electrode 27 by using patterning technology with photoresist.

In the method of manufacturing the field-effect transistor of this preferred embodiment, the sidewall of the mesa pattern 110 is not subjected to thermal etch because the heat treatment process for thermal diffusion shown in Fig.5B is performed before the mesa etching process shown in Fig.5C. This reduces the lattice defects in the device region of the field-effect transistor and reduces the noise sources, which results in improved characteristics of the field-effect transistor.

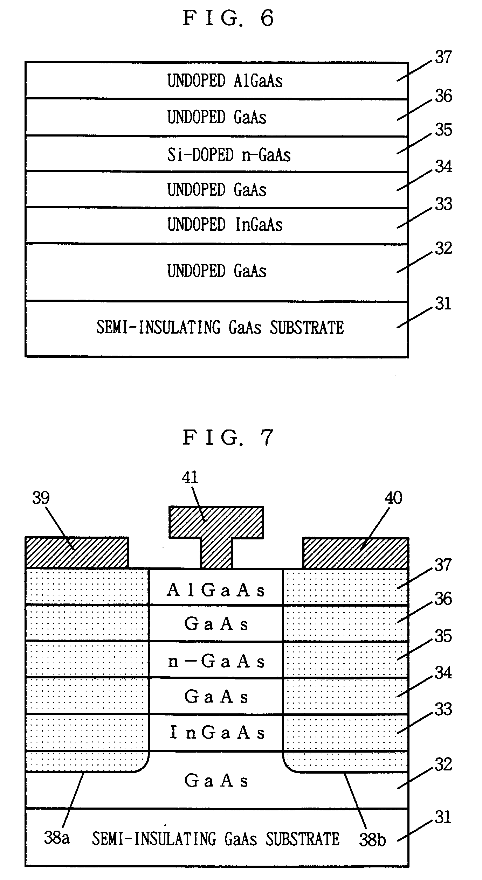

Fig.6 is a schematic cross section showing the structure of an epitaxial growth substrate used in a field-effect transistor according to a third embodiment of the present invention and Fig.7 is a schematic cross section showing the structure of a field-effect transistor using the epitaxial growth substrate of Fig.6. This field-effect transistor has both of the low-noise operating characteristic and the high-power operating characteristic, which is called a TMT (Two Mode Channel FET) device.

In Fig.6, sequentially formed by epitaxial growth on a semi-insulating GaAs substrate 31 are a 8000-Å-thick undoped GaAs layer (buffer layer) 32, a 100-Å-thick undoped InGaAs layer (low-noise drift layer) 33, a 50-Å-thick undoped GaAs layer 34, a 400-Å-thick Si-doped n-type GaAs layer (high-power drift layer) 35, an undoped GaAs layer 36, and a 300-Å-thick undoped AlGaAs layer (barrier layer) 37. The doping concentration of the n-type GaAs layer 35 is 1×10¹⁸cm⁻³. The layers 32-37 are continuously grown at a growth temperature of 500°C.

In Fig.7, a gate electrode 41 forming a Schottky contact with the undoped AlGaAs layer 37 is formed in the center of the AlGaAs layer 37, and a source electrode 39 and a drain electrode 40 are formed on either side of the gate electrode 41. Right under the source electrode 39 and the drain electrode 40, n-type highly conductive regions 38a and 38b are formed by an Si ion-implantation, which are in ohmic contact with the source electrode 39 and the drain electrode 40. For the conditions of ion implantation, the implantation energy is 100 keV and the dose is 4×10¹³cm⁻². After the ion implantation, activating annealing is applied for 5 seconds at 880°C.

An AuGe/Ni/Au triple-layered metal layer which is alloyed by a thermal treatment at 450°C is used as the source electrode 39 and the drain electrode 40, and an Ti/Pd/Au triple-layered metal layer is used as the gate electrode 41.

The TMT device described above is manufactured by adopting the manufacturing method of the first or second embodiment. Accordingly, the device region in which the TMT device is formed is mesa-shaped and its sidewall is not damaged by thermal etching in the heat treatment. Accordingly, crystal defects in the device region are reduced and noise sources are reduced, and hence the characteristics are improved.

In the TMT device shown in Fig.7, the depletion layer downwardly extends when the gate potential is deep and electrons supplied from the n-type GaAs layer 35 mainly drift in the undoped InGaAs layer 33. In this case, the electrons are well confined in the quantum well in the undoped InGaAs layer 33. They are hence less affected by impurities in the heavily doped n-type GaAs layer 35, thus providing the super-low-noise characteristic.

When the gate potential is shallow, the depletion layer shrinks and the electrons drift mainly in the n-type GaAs layer 35. Accordingly, the heavily doped n-type GaAs layer 35 serves as a channel, providing a high and plateau-shaped transconductance and hence the high-power characteristics.

We produced a plurality of samples with the undoped GaAs layer 36 having various thicknesses ranging from 0 to 100 Å and measured the device characteristics. The gate length was 0.5 µm and the gate width was 400 µm.

Measured as the device characteristics were standard deviation of the drain saturation current measured with 100 TMT devices in a wafer, standard deviation of the drain saturation current of TMT devices in 10 wafers, and phase noise of the TMT devices. The standard deviation of the drain saturation current in a wafer indicates uniformity of the device characteristics in a wafer. The standard deviation of the drain saturation current among wafers indicates reproducibility of the device characteristics. The average of the drain saturation current was about 100 mA. The phase noise indicates conditions of defects.

Table 2 shows the relation among the film thickness of the undoped GaAs layer 36, the electron concentration in the heterojunction interface (the interface between the undoped GaAs layer 36 and the undoped AlGaAs layer 37), the standard deviation of the drain saturation current and the phase noise. The electron concentration in the heterojunction interface was obtained by calculation on the basis of the carrier concentration of the n-type GaAs layer 35 and the film thickness of the undoped GaAs layer 36.

**Table 2**

| Thickness of undoped GaAs layer (Å) | Electron concentration in heterojunction interface (cm⁻²) | Standard deviation of drain saturation current (mA) | | Phase noise (1KHz offset) (dBc/H₂) |
|---|---|---|---|---|
| | | in-wafer | inter-wafer | |
| 0 | 4.6×10¹⁶ | 5.7 | 15.7 | -55.1 |
| 20 | 2.7×10¹⁶ | 4.3 | 9.7 | -58.2 |
| 30 | 1.5×10¹⁶ | 2.9 | 6.3 | -60.1 |
| 50 | 9.2×10¹⁵ | 2.2 | 3.0 | -63.0 |
| 100 | 8.0×10¹⁵ | 2.1 | 3.0 | -63.0 |

As is clear from Table 2, the standard deviations of the drain saturation current in a wafer and among wafers decrease as the thickness of the undoped GaAs layer 36 increases. This shows that the uniformity of the device characteristics in a wafer and the reproducibility of the device characteristics become more excellent as the thickness of the undoped GaAs layer 36 increases.

As the thickness of the undoped GaAs layer 36 increases, the phase noise decreases, too. This shows that the defects decrease as the thickness of the undoped GaAs layer 36 becomes greater.

Particularly, when the thickness of the undoped GaAs layer 36 was 50 Å, the electron concentration in the heterojunction interface was about 1×10¹⁶cm⁻³, the in-wafer and inter-wafer standard deviations of the drain saturation current were as small as 2.2 mA and 3.0 mA, and the phase noise was as low as -63.0 dBc/Hz. When the thickness of the undoped GaAs layer 36 was increased over 50 Å, the electron concentration in the heterojunction interface further decreased but the device characteristics hardly changed.

The results show that setting the thickness of the undoped GaAs layer 36 so that the electron concentration in the heterojunction interface between the undoped GaAs layer 36 and the undoped AlGaAs layer 37 is approximately 1×10¹⁶cm⁻³ or smaller enables stable production of TMT devices having good device characteristics.

As stated above, with the TMT device of the third embodiment, the device region is formed by mesa etching after the heat treatment process is finished. This prevents the sidewall of the device region from being subjected to thermal etch. Hence a TMT device having good characteristics with reduced noise sources can be manufactured.

Further, the formation of the undoped GaAs layer 36 between the n-type GaAs layer 35 and the undoped AlGaAs layer 37 suppresses the diffusion of dopant in the n-type GaAs layer 35 and the mutual diffusion of the component elements in the heterojunction interface between the GaAs layer and the AlGaAs layer and reduces the formation of defects due to vacancies. As a result, variations in the doping profile and in the edge profile of the conduction band in the heat treatment decrease to improve the in-wafer uniformity of the device characteristics and the reproducibility of the device characteristics, and deterioration of the device characteristics due to the occurrence of defects is suppressed. Then the error between the actual device characteristics and designed values becomes smaller, enabling stable production of TMT devices providing a good performance with excellent controllability.

Although the undoped GaAs layer 36 is provided between the n-type GaAs layer 35 and the undoped AlGaAs layer 37 in this embodiment, an n-type GaAs layer or a p-type GaAs layer with a low doping concentration of 10¹⁶cm⁻³ or lower may be provided in place of the undoped GaAs layer 36. In this case, in the same way, setting the thickness of the low-concentration n-type GaAs layer or p-type GaAs layer so that the electron concentration in the heterojunction interface is about 1×10¹⁶cm⁻³ or lower provides the same effects as the embodiment.

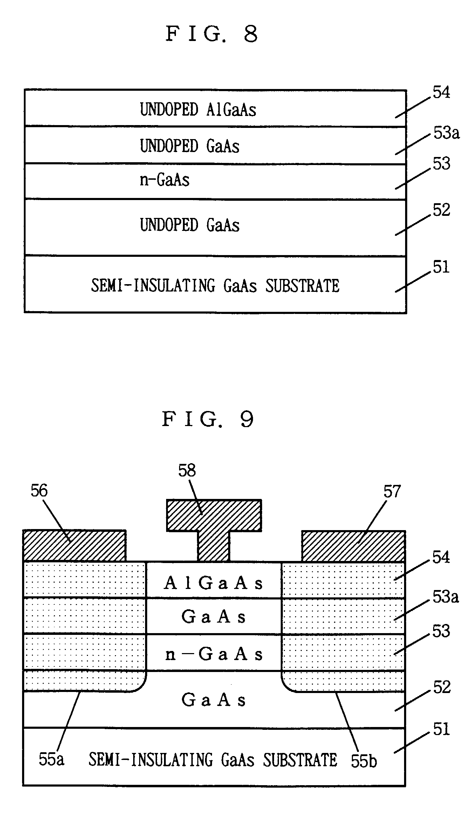

Fig.8 is a schematic cross section showing the structure of an epitaxial growth substrate used in a field-effect transistor according to a fourth embodiment of the present invention and Fig.9 is a schematic cross section of the field-effect transistor using the epitaxial growth substrate of Fig.8.

In Fig.8, sequentially formed on a semi-insulating GaAs substrate 51 by epitaxial growth are an undoped GaAs buffer layer 52, an n-type GaAs channel layer 53, an undoped GaAs layer 53a and an undoped AlGaAs barrier layer 54. The carrier concentration of the n-type GaAs channel layer 53 is 1×10¹⁸cm⁻³, for example.

In Fig.9, a gate electrode 58 in Schottky contact with the AlGaAs barrier layer 54 is formed in the center of the AlGaAs barrier layer 54 and a source electrode 56 and a drain electrode 57 are formed on either side of the gate electrode 58. Formed right under the source electrode 56 and the drain electrode 57 are Si-ion-implanted n-type highly conductive regions 55a and 55b, which are in ohmic contact with the source electrode 56 and the drain electrode 57.

Particularly, the film thickness of the undoped GaAs layer 53a is set so that the electron concentration in the heterojunction interface between the undoped GaAs layer 53a and the undoped AlGaAs barrier layer 54 is approximately 1×10¹⁶cm⁻³ or lower.

The field-effect transistor of this embodiment is manufactured by using the manufacturing method of the first or second embodiment. Accordingly, the device region in which the field-effect transistor is formed is in the mesa shape, whose sidewall is not damaged by thermal etching in the heat treatment. This allows reduction of the crystal defects in the device region, and hence reduction of the noise sources, and provides improved characteristics.

In the field-effect transistor of this embodiment, the undoped GaAs layer 53a is provided between the n-type GaAs channel layer 53 and the undoped AlGaAs barrier layer 54 so that the electron concentration in the heterojunction interface between the AlGaAs layer and the GaAs layer is approximately 1×10¹⁶cm⁻³ or lower. This suppresses the formation of vacancies in the vicinity of the heterojunction interface even when a high-temperature heat treatment is applied to form the n-type highly conductive regions 55a and 55b. Then the diffusion of the dopant in the n-type GaAs channel layer 53 and the mutual diffusion of the component elements in the vicinity of the heterojunction interface are suppressed, and the formation of defects due to vacancies is reduced. As a result, the variations in the doping profile and the edge profile of the conduction band due to the high-temperature heat treatment become smaller and the in-wafer uniformity of the device characteristics and the reproducibility of the device characteristics are therefore improved, and the deterioration of the device characteristics due to the formation of defects is suppressed. This reduces the error between actual device characteristics and designed values, which allows high-performance field-effect transistors to be stably fabricated with good controllability.

Although the undoped GaAs layer 53a is provided between the n-type GaAs channel layer 53 and the undoped AlGaAs layer 54 in this embodiment, an n-type GaAs layer or a p-type GaAs layer with a doping concentration as low as 10¹⁶cm⁻³ or lower may be provided in place of the undoped GaAs layer 53a.

The heterojunction structures of the field-effect transistors of the third and fourth embodiments may be applied to various kinds of semiconductor devices having the low-noise characteristic other than the field-effect transistors. For example, the heterojunction structures above may be applied to MESFET (Metal Semiconductor Field-Effect Transistor) and HEMT (High-Electron Mobility Transistor) produced by crystal growth. This provides improved characteristics as well.

Furthermore, although the embodiments shown in Fig.7 and Fig.9 have been described as field-effect transistors having an AlGaAs/n-type GaAs heterojunction, the heterojunction structures of the third and fourth embodiments can also be applied to field-effect transistors and other semiconductor devices having a heterojunction of InGaP/n-type GaAs, AlGaAs/n-type InGaAs, GaAs/n-type InGaAs, InGaP/n-type InGaAs, InAlAs/n-type InGaAs, InP/n-type InGaAs, and the like. This provides the same effects as the above-described embodiments.

Although the embodiments above have described applications of the above-mentioned heterojunction structures to semiconductor devices having an n-type channel, they can be applied to semiconductor devices having a p-type channel, as well.

While the invention has been described in detail, the foregoing description is in all aspects illustrative and not restrictive. It is understood that numerous other modifications and variations can be devised without departing from the scope of the invention.

## Claims

1. A method of manufacturing a semiconductor device, comprising the steps of:
doping a semiconductor substrate with an impurity element to form an impurity-doped region;
applying a heat treatment to activate said impurity-doped region; and
forming a stepped portion for device isolation on said semiconductor substrate by etching after said heat treatment.

2. The method of manufacturing a semiconductor device according to claim 1, wherein said stepped portion forming step includes removing a certain region of said semiconductor substrate by mesa etching.

3. The method of manufacturing a semiconductor device according to claim 1, wherein said step of doping with said impurity element includes forming a pair of said impurity-doped regions at a certain distance in said semiconductor substrate, and
said stepped portion forming step includes forming a mesa-shaped device region including said pair of impurity-doped regions.

4. The method of manufacturing a semiconductor device according to claim 3, further comprising the step of forming a gate electrode on said semiconductor substrate between said pair of impurity-doped regions after said mesa-shaped device region is formed.

5. The method of manufacturing a semiconductor device according to claim 4, wherein said semiconductor substrate comprises,
a first semiconductor layer doped with an impurity element of one conductivity type,
a second semiconductor layer formed on said first semiconductor layer, composed of the same semiconductor material as said first semiconductor layer, and undoped or having a carrier concentration of 10¹⁶cm⁻³ or lower, and
a third semiconductor layer formed on said second semiconductor layer and forming a heterojunction with said second semiconductor layer.

6. The method of manufacturing a semiconductor device according to claim 5, wherein said first semiconductor layer has a larger electron affinity than said third semiconductor layer,
said one-conductivity-type impurity element is an n-type impurity element, and
said second semiconductor layer has an electron concentration of 10¹⁶cm⁻³ or lower in the vicinity of the interface between said second semiconductor layer and said third semiconductor layer.

7. The method of manufacturing a semiconductor device according to claim 6, wherein said first semiconductor layer, said second semiconductor layer and said third semiconductor layer are each formed of a Group III-V compound semiconductor.

8. The method of manufacturing a semiconductor device according to claim 7, wherein said first semiconductor layer and said second semiconductor layer are formed of GaAs, and said third semiconductor layer is formed of AlGaAs or InGaP.

9. The method of manufacturing a semiconductor device according to claim 7, wherein said first semiconductor layer and said second semiconductor layer are formed of InGaAs, and
said third semiconductor layer is formed of GaAs, AlGaAs, InGaP, InAlAs, or InP.

10. A method of manufacturing a semiconductor device, comprising the steps of:
forming a film serving as a source of diffusion of an impurity element on a semiconductor substrate;
applying a heat treatment to cause said impurity element to diffuse into said semiconductor substrate from said film serving as a source of diffusion; and
forming a stepped portion for device isolation on said semiconductor substrate by etching after said heat treatment.

11. The method of manufacturing a semiconductor device according to claim 10, wherein said stepped portion forming step includes removing a certain region of said semiconductor substrate by mesa etching.

12. The method of manufacturing a semiconductor device according to claim 10, wherein said heat treatment step includes forming a pair of impurity-doped regions at a certain distance in said semiconductor substrate, and
said stepped portion forming step includes forming a mesa-shaped device region including said pair of impurity-doped regions.

13. The method of manufacturing a semiconductor device according to claim 12, further comprising the step of forming a gate electrode on said semiconductor substrate between said pair of impurity-doped regions after said mesa-shaped device region is formed.

14. The method of manufacturing a semiconductor device according to claim 13, wherein said semiconductor substrate comprises,
a first semiconductor layer doped with an impurity element of one conductivity type,
a second semiconductor layer formed on said first semiconductor layer, composed of the same semiconductor material as said first semiconductor layer, and undoped or having a carrier concentration of 10¹⁶cm⁻³ or lower, and
a third semiconductor layer formed on said second semiconductor layer and forming a heterojunction with said second semiconductor layer.

15. The method of manufacturing a semiconductor device according to claim 14, wherein said first semiconductor layer has a larger electron affinity than said third semiconductor layer,
said one-conductivity-type impurity element is an n-type impurity element, and
said second semiconductor layer has an electron concentration of 10¹⁶cm⁻³ or lower in the vicinity of the interface between said second semiconductor layer and said third semiconductor layer.

16. The method of manufacturing a semiconductor device according to claim 15, wherein said first semiconductor layer, said second semiconductor layer and said third semiconductor layer are each formed of a Group III-V compound semiconductor.

17. The method of manufacturing a semiconductor device according to claim 16, wherein said first semiconductor layer and said second semiconductor layer are formed of GaAs, and
said third semiconductor layer is formed of AlGaAs or InGaP.

18. The method of manufacturing a semiconductor device according to claim 16, wherein said first semiconductor layer and said second semiconductor layer are formed of InGaAs, and
said third semiconductor layer is formed of GaAs, AlGaAs, InGaP, InAlAs, or InP.

19. A method of manufacturing a semiconductor device, comprising the steps of:
forming a certain layer in or on a semiconductor substrate;
applying a heat treatment to said semiconductor substrate having said certain layer; and
forming a stepped portion for device isolation on said semiconductor substrate after said heat treatment.

20. The method of manufacturing a semiconductor device according to claim 19, further comprising the step of forming a field-effect-type semiconductor device in a region isolated by said stepped portion.

21. The method of manufacturing a semiconductor device according to claim 19, wherein said semiconductor substrate includes a compound semiconductor layer.

22. A semiconductor device comprising:
a semiconductor substrate including a certain layer;
a pair of high-concentration doped regions formed at a certain distance in said semiconductor substrate by doping with an impurity element;
a gate region formed between said pair of high-concentration doped regions; and
a mesa-shaped device region including said gate region and said pair of high-concentration doped regions and formed,in the surface of said semiconductor substrate, the side wall of said mesa-shaped device region being not subjected to thermal etching.

23. The semiconductor device according to claim 22, wherein in the gate width direction, the width of said mesa-shaped device region in said gate region is equal to or smaller than the width of said mesa-shaped device region in said high-concentration doped regions.

24. The semiconductor device according to claim 23, wherein said semiconductor substrate comprises,
a first semiconductor layer doped with an impurity element of one conductivity type,
a second semiconductor layer formed on said first semiconductor layer, composed of the same semiconductor material as said first semiconductor layer, and undoped or having a carrier concentration of 10¹⁶cm⁻³ or lower, and
a third semiconductor layer formed on said second semiconductor layer and forming a heterojunction with said second semiconductor layer.

25. The semiconductor device according to claim 24, wherein said first semiconductor layer has a larger electron affinity than said third semiconductor layer,
said one-conductivity-type impurity element is an n-type impurity element, and
said second semiconductor layer has an electron concentration of 10¹⁶cm⁻³ or lower in the vicinity of the interface between said second semiconductor layer and said third semiconductor layer.

26. The semiconductor device according to claim 25, wherein said first semiconductor layer, said second semiconductor layer and said third semiconductor layer are each formed of a Group III-V compound semiconductor.

27. The semiconductor device according to claim 26, wherein said first semiconductor layer and said second semiconductor layer are formed of GaAs, and
said third semiconductor layer is formed of AlGaAs or InGaP.

28. The semiconductor device according to claim 26, wherein said first semiconductor layer and said second semiconductor layer are formed of InGaAs, and
said third semiconductor layer is formed of GaAs, AlGaAs, InGaP, InAlAs, or InP.

29. A semiconductor device comprising:
a first semiconductor layer doped with an impurity element of one conductivity type;
a second semiconductor layer formed on said first semiconductor layer, formed of the same semiconductor material as said first semiconductor layer, and undoped or having a carrier concentration of 10¹⁶cm⁻³ or lower; and
a third semiconductor layer formed on said second semiconductor layer and forming a heterojunction with said second semiconductor layer.

30. The semiconductor device according to claim 29, wherein said first semiconductor layer has a larger electron affinity than said third semiconductor layer,
said one-conductivity-type impurity element is an n-type impurity element, and
said second semiconductor layer has an electron concentration of 10¹⁶cm⁻³ or lower in the vicinity of the interface between said second semiconductor layer and said third semiconductor layer.

31. The semiconductor device according to claim 30, wherein said first semiconductor layer, said second semiconductor layer and said third semiconductor layer are each formed of a Group III-V compound semiconductor.

32. The semiconductor device according to claim 31, wherein said first semiconductor layer and said second semiconductor layer are formed of GaAs, and
said third semiconductor layer is formed of AlGaAs or InGaP.

33. The semiconductor device according to claim 31, wherein said first semiconductor layer and said second semiconductor layer are formed of InGaAs, and
said third semiconductor layer is formed of GaAs, AlGaAs, InGaP, InAlAs, or InP.
